# EUROPÄISCHE PATENTSCHRIFT

(11) **EP 1 119 031 B1**
(45) Veröffentlichungstag und Bekanntmachung des Hinweises auf die Patenterteilung: **22.10.2014**
(21) Anmeldenummer: 01101103.8
(22) Anmeldetag: 18.01.2001
(51) Int. Cl.: H01L 21/02, H01L 21/67, H01L 21/306

(54) **Verfahren zur Herstellung einer Halbleiterscheibe**
Process for producing a semiconductor wafer
Procédé de fabrication d'une pastille semi-conductrice

(30) Priorität: 20.01.2000 DE 10002354
(43) Veröffentlichungstag der Anmeldung: 25.07.2001
(73) Patentinhaber: Siltronic AG, 81737 München (DE)
(72) Erfinder: Schwab, Günter, 84547 Emmerting (DE); Franke, Helmut, 84489 Burghausen (DE); Schöfberger, Manfred, 84367 Reut (DE)
(74) Vertreter: Rimböck, Karl-Heinz

(56) Entgegenhaltungen:
- EP-A- 0 637 064
- DE-A- 19 805 835

## Beschreibung

Die vorliegende Erfindung betrifft ein Verfahren zur Herstellung einer Halbleiterscheibe durch Ätzen und gegebenenfalls Polieren der Halbleiterscheibe.

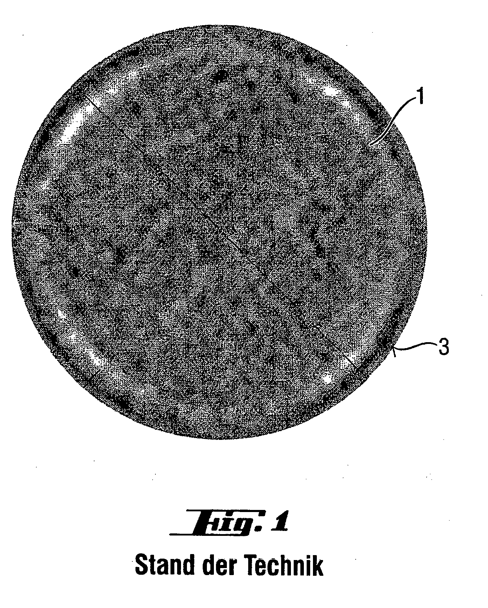

Verfahren zum Ätzen einer Halbleiterscheibe sind beispielsweise in der US-5,451,267, in der EP-930 640 A2 und der EP-673 545 B1 beschrieben. Dabei strömt ein Ätzmedium frontal gegen eine Kante der Halbleiterscheibe, während sich die Halbleiterscheibe gegebenenfalls dreht. Wird eine derartig behandelte Halbleiterscheibe später einseitig poliert, so ist in einem Randbereich der polierten Seite der Halbleiterscheibe eine Erhöhung feststellbar, die sich ringförmig entlang des Umfangs der Halbleiterscheibe erstreckt. Die Oberflächenstruktur einer solchen Halbleiterscheibe ist in Figur 1 dargestellt.

In der EP-637 064 A2 ist ein Verfahren beschrieben, mit dem eine Seite einer Halbleiterscheibe geätzt wird, wobei eine hohe Ebenheit der geätzten Scheibe erzielt wird.

Aufgabe der vorliegenden Erfindung ist es, ein Verfahren zur Herstellung einer Halbleiterscheibe anzugeben, bei dem die Entstehung der erwähnten, im Englischen edge gutter genannten Erhöhung vermieden wird.

Die Aufgabe wird gelöst durch ein Verfahren nach Anspruch 1.

Die Erfindung wird nachfolgend mit Unterstützung von Figuren weiter erläutert. Figur 2 zeigt in Draufsicht eine Halbleiterscheibe und ein Schutzschild gemäß der Erfindung. Figur 3 zeigt die Anordnung einer Halbleiterscheibe relativ zur Strömungsrichtung des Ätzmediums. In den Figuren 4 und 5 sind der Stand der Technik und die Erfindung einander gegenübergestellt, um die Wirkung des Schutzschilds zu verdeutlichen.

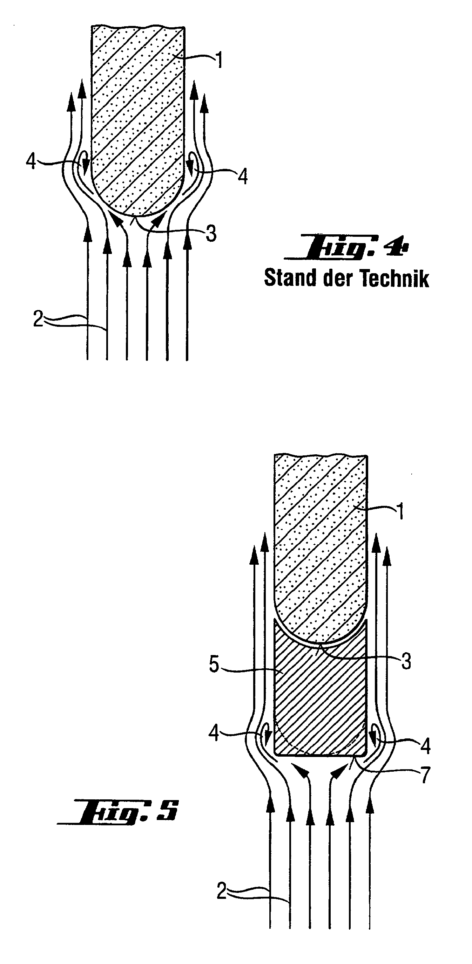

Untersuchungen der Erfinder haben ergeben, daß sich das Ätzmedium hinter der Kante der Halbleiterscheibe 1 verwirbelt, wenn das Ätzmedium nach der bisher üblichen Art in einem laminaren Strom 2 frontal gegen die Kante 3 der Halbleiterscheibe strömt. Diese Situation ist in Figur 4 dargestellt. Durch die Verwirbelungen 4 entsteht ein verstärkter Ätzabtrag im Randbereich auf beiden Seiten der Halbleiterscheibe. Nach einer Politur einer Seite der Halbleiterscheibe wird daraus die erwähnte Erhöhung im Randbereich der polierten Seite der Halbleiterscheibe.

Wenn gemäß der Erfindung ein Schutzschild vor der Kante der Halbleiterscheibe angeordnet wird, dann wird eine sich ausbildende turbulente Grenzschicht des Ätzmediums von den Seiten der Halbleiterscheibe ferngehalten.

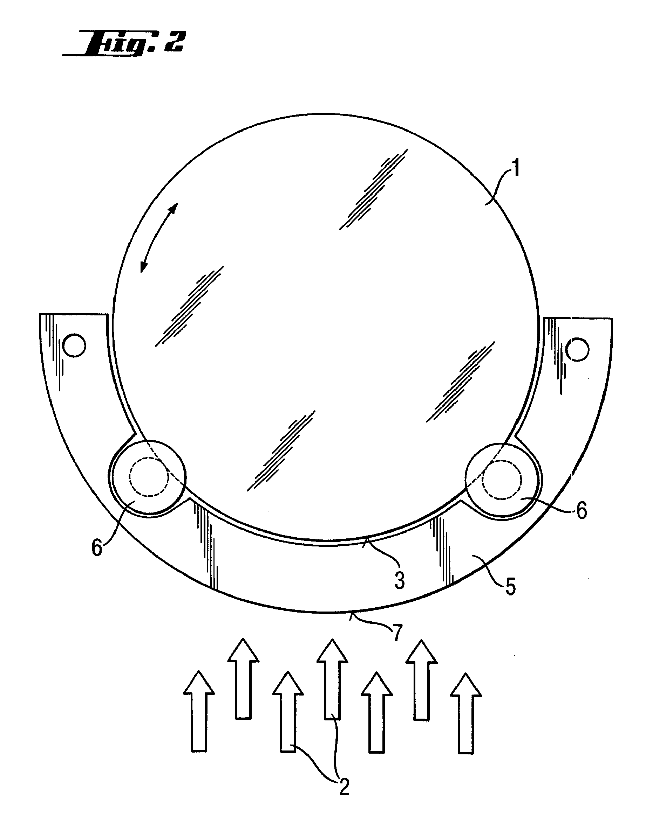

In Figur 2 ist dargestellt, wie die von einem Ätzmedium laminar angeströmte Kante der Halbleiterscheibe von einem Schutzschild abgeschirmt wird. Das Schutzschild 5 verfügt in der gezeigten Ausführungsform über Paare von Führungen 6, zwischen denen die Halbleiterscheibe 1 gehalten und gegebenenfalls gedreht wird. Die Wirkung des Schutzschilds, dessen Dicke vorzugsweise der Dicke der Halbleiterscheibe entspricht, ist in Figur 5 deutlich gemacht. Eine laminare Strömung 2 des Ätzmediums trifft auf der Stirnseite 7 des Schutzschilds 5 auf. Unmittelbar hinter der Stirnseite bilden sich auf beiden Seiten des Schutzschilds Grenzschichten mit turbulenter Strömung 4 aus. Dies geschieht auch dann, wenn die Stirnseite wie in der Figur 5 angedeutet ist, eine abgerundete Form besitzt. Bis das Ätzmedium die Halbleiterscheibe 1 erreicht, ist die Strömung nur noch laminar, so daß ein gleichmäßiger Ätzabtrag gewährleistet ist. Dies ist nicht der Fall, wenn auf das Schutzschild verzichtet wird und das Ätzmedium frontal gegen die Kante der Halbleiterscheibe strömt.

Eine Ausgestaltung der Erfindung sieht vor, ein Schutzschild vor Kante der Halbleiterscheibe anzuordnen, die Halbleiterscheibe aus der Strömungsrichtung zu neigen und später die zweite Seite der Halbleiterscheibe zu polieren.

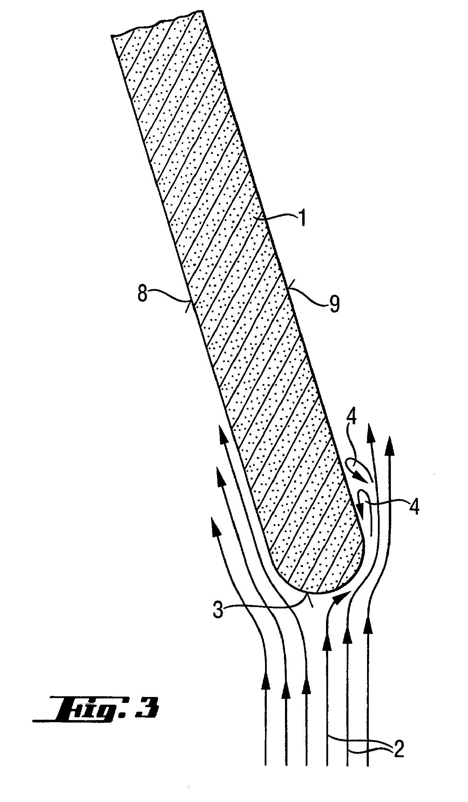

Figur 3 zeigt die Situation, wenn die Halbleiterscheibe gemäß dieser Ausgestaltung um vorzugsweise 1 bis 10° aus der Strömungsrichtung des zur Halbleiterscheibe fließenden Ätzmediums geneigt angeordnet wird. Dann besteht zwischen der Strömungsrichtung des laminar zur Kante der Halbleiterscheibe strömenden Ätzmediums 2 und einer ersten Seite 8 der Halbleiterscheibe 1 ein Winkel von kleiner als 180° und zwischen der Strömungsrichtung des laminar zur Halbleiterscheibe strömenden Ätzmediums 2 und einer zweiten Seite 9 der Halbleiterscheibe 1 ein Winkel von größer als 180°. Beim Auftreffen des Ätzmediums auf die Kante 3 der Halbleiterscheibe verändert sich die Richtung der laminaren Strömung entsprechend der Neigung der Halbleiterscheibe. Darüber hinaus bildet sich nur hinter der Kante an der zweiten Seite 9 der Halbleiterscheibe 1 eine Grenzschicht mit turbulenter Strömung 4 aus, die in diesem Bereich der Halbleiterscheibe einen erhöhten Ätzabtrag bewirkt. Die entstehende einseitige Unebenheit der Halbleiterscheibe wird später beseitigt, indem die zweite Seite der Halbleiterscheibe poliert wird.

## Patentansprüche

1. Verfahren zur Herstellung einer Halbleiterscheibe durch Ätzen der Halbleiterscheibe in einem laminar entlang zweier Seitenflächen der Halbleiterscheibe strömenden Ätzmedium, **dadurch gekennzeichnet, dass** die Halbleiterscheibe von einem Schutzschild gehalten wird, der eine Kante der Halbleiterscheibe vor dem anströmenden Ätzmedium abschirmt und den Zugang des Ätzmediums zu den Seitenflächen frei lässt.

2. Verfahren nach Anspruch 1, **dadurch gekennzeichnet, dass** die Halbleiterscheibe während des Ätzens um einen Winkel von 1 bis 10° aus einer Strömungsrichtung des Ätzmediums geneigt ist.

3. Verfahren nach Anspruch 1 oder Anspruch 2, **dadurch gekennzeichnet, dass** die Halbleiterscheibe während des Ätzens gedreht wird.

## Claims

1. Method for producing a semiconductor wafer by etching the semiconductor wafer in an etching medium flowing in a laminar fashion along two side surfaces of the semiconductor wafer, **characterized in that** the semiconductor wafer is held by a protective shield that shields an edge of the semiconductor wafer from the flowing etching medium and allows the etching medium to have free access to the side surfaces.

2. Method according to Claim 1, **characterized in that** the semiconductor wafer is inclined by an angle of 1 to 10° from a flow direction of the etching medium during etching.

3. Method according to Claim 1 or Claim 2, **characterized in that** the semiconductor wafer is rotated during etching.

## Revendications

1. Procédé de fabrication d'une pastille semi-conductrice par gravure chimique de la pastille semi-conductrice dans un milieu de gravure chimique s'écoulant sous forme laminaire le long de deux faces latérales de la pastille semi-conductrice, **caractérisé en ce que** la pastille semi-conductrice est retenue par un panneau de protection qui protège un côté de la pastille semi-conductrice contre le milieu de gravure chimique affluant et qui expose l'accès du milieu de gravure chimique aux faces latérales.

2. Procédé selon la revendication 1, **caractérisé en ce que** la pastille semi-conductrice est inclinée pendant la gravure chimique suivant un angle de 1 à 10° depuis une direction d'écoulement du milieu de gravure chimique.

3. Procédé selon la revendication 1 ou la revendication 2, **caractérisé en ce que** la pastille semi-conductrice est tournée pendant la gravure chimique.
